# EUROPEAN PATENT APPLICATION

(11) **EP 4 560 772 A1**
(43) Date of publication of application: **28.05.2025**
(21) Application number: 23212321.6
(22) Date of filing: 27.11.2023
(51) Int. Cl.: H01M 10/42, G01R 31/36, G01R 31/364, G01R 31/378, G01R 31/385, H01M 10/48, H01M 50/105, H01M 50/569

(54) **DEVICE, SYSTEM AND METHOD FOR MEASURING AN ELECTRICAL PARAMETER OF A BATTERY CELL**

(71) Applicant: LG ENERGY SOLUTION, LTD., Seoul 07335 (KR)
(72) Inventor: YOO, Kyoung Suk, 34122 Daejeon (KR)
(74) Representative: Goddar, Heinz J.

(57) **Abstract**

A device (1) for measuring electrical parameters, in particular an insulation voltage, of a battery cell , comprises at least one probe (3) including a conductor (5) configured for electrically coupling to avoltage sensor; wherein the conductor (5) has an arced contact surface (51) configured for engaging the battery cell to be measured ; and a biasing member (7) configured for mounting the conductor (5) resiliently in a first direction (F).

## Description

### Technical Field

The present disclosure relates to a device for measuring at least one electrical parameter, in particular an insulation voltage, of a battery cell, in particular a pouch type battery cell. The present disclosure also relates to a system comprising two or more such devices. Furthermore, the present disclosure relates to a method for measuring at least one electrical parameter, in particular an insulation voltage, of a pouch-type battery cell for measuring at least one electrical parameter, in particular an insulation voltage, of the pouch-type battery cell using at least one or more of the devices according to the present disclosure.

### Technical Background

In modern society, as portable devices such mobile phones, notebook computers, camcorder and digital cameras have become popular, the development of battery technology is of great significance. In addition, chargeable/dischargeable secondary batteries have become indispensable power sources for electric vehicles (EV), hybrid electric vehicles (HEV), plug-in hybrid electric vehicles (P-HEV) and the like, in the attempt to solve air pollution, decrease carbon dioxide emissions, and the like, caused by existing combustion engine vehicles using fossil fuel. Therefore, there is a growing need for improvements of secondary batteries.

Currently commercialized secondary batteries include nickel cadmium batteries, nickel hydrogen batteries, nickel zinc batteries, and lithium secondary batteries. Among these, the lithium secondary batteries have come into the spotlight because of various beneficial aspects, for example, they hardly exhibit memory effects compared to nickel-based secondary batteries and thus may be liberally charged and discharged, and they display very low self-discharge rates and high energy density.

A secondary battery may be classified based on the shape of battery case into a cylindrical battery having an electrode assembly mounted in a cylindrical metal can, a prismatic battery having an electrode assembly mounted in a prismatic metal can, and a pouch-type battery. The pouch-type secondary battery generally accommodates an electrode assembly having a structure in which electrodes and separators are alternately arranged within a pouch-shaped case made of a laminated aluminum sheet.

A secondary battery showing leakage, short circuits or electrical connections between components that should be isolated from each other is dysfunctional and must be identified to be sorted out from further use.

Battery cell inspection equipment and methods for measuring electrical characteristics of pouch-type battery cells, particularly insulation voltage, are described in KR 2023 0033529 A or KR 2020 0050697 A.

### DETAILED DESCRIPTION OF THE INVENTION

### Technical Problem

It is an objective of the present disclosure to provide a device, a system and method which overcome the drawbacks of the prior art, in particular being capable of reliably and continuously detecting faulty batteries, particularly pouch type batteries. In particular, it is an objective of the present disclosure provide a method, a system and a device including a reliable and durable probe capable of performing without causing damage to the pouch-type batteries and displaying little to no physical deterioration. It may be an objective to provide a method, system and/or device with a probe which can measure large quantities of batteries in a short timeframe while posing little to no risk of damaging the tested batteries as well as the device itself. Preferably, the system or device according to the present disclosure shall be particularly simple to inspect and maintain, preferably including easy assembly and disassembly.

### Technical Solution

Accordingly, a device for measuring at least one electrical parameter, in particular an insulation voltage, of a battery cell, in particular a pouch type battery cell, is provided. It may be preferred that the device is not only suitable but specifically configured for measuring an insulation voltage of a pouch-type battery cell. The device according to the present disclosure comprises at least one probe. The probe includes a conductor and a biasing member. The conductor is configured for electrically coupling to a current- and/or voltage-sensor. It may be preferred that the conductor is configured for electrically coupling to a voltage sensor so as to determine a voltage, particularly the insulation voltage, in particular between a point of contact of the probe and at least one reference point. A reference point may correspond to a ground level and/or to a reference measurement at a first and/or second electrode of the target pouch-type battery. Alternatively or additionally, a reference point may correspond to a second or further measurement taken by another device on the same target pouch-type battery cell (battery cell to be measured), preferably at a position distanced from the position engaged by the conductor, such as along a different edge.

The conductor has an arced contact surface configured for engaging the battery cell to be measured. The arced contact surface may be concave or, preferably, convex. The arced contact surface may be formed as a surface continuous in the (circumferential) arcing direction and continuous (in the axial direction) perpendicular to the (circumferential) arcing direction and to the radial direction. The continuous arced contact surface may in particular have an axial width and/or circumferential length of no no less than 5 mm, in particular no less than 10 mm, preferably no less than 20 mm. The arced contact surface may preferably be configured with a radius of curvature between 5 mm and 5000 mm, in particular between 10 mm and 1000 mm. The radius of curvature may in particular be no less than 12 mm, preferably no less than 15 mm, more preferably no less than 20 mm. The radius of curvature may in particular be no more than 500 mm, preferably no more than 250 mm, more preferably no more than 100 mm.

The biasing member is configured for mounting the conductor resiliently in the first direction. The conductor is mounted by the biasing member movable forward and backward in the first direction. The conductor can be moved in part, preferably in the part of the conductor realizing the contact surface, or entirely, forward and backward in the first direction using the resiliency of the biasing member. For example, the conductor can be movable backwards in the first direction when subjected to an increasing force of resistance, due to deformation of the biasing member, for instance compression and/or deflection, preferably due to engaging a target battery cell, in particular a target pouch type battery cell. Alternatively or additionally, the conductor can be movable forward in the first direction under the influence of a deformation of the biasing member, for example as the probe is released from a target battery cell, in particular a target pouch type battery cell, and the biasing member reverts from its deformed state to a relaxed state. In particular, the arced contact surface may have a width crosswise with respect to the first direction and/or crosswise to the radial direction of curvature of no less than 5 mm, in particular no less than 10 mm, preferably no less than 20 mm. The width of the arced contact surface may in particular be no more than 100 mm, preferably no more than 50 mm. The width direction preferably corresponds to an axial direction relative to the radius of curvature. The biasing means in conjunction with the arced contact surface acts as a safeguard protecting the target pouch-type battery cell from being damaged in a collision with the probe.

In a preferred embodiment, the conductor is provided with a convex side of the contact surface oriented to face the battery cell to be measured in a first direction. The arced contact surface may in particular be configured to be moveable on the pouch-type battery case in a skid-like manner. The provision of the convexely arced contact surface held by the biasing means allows the device to reliably engage a target position on a battery cell, in particular a pouch type battery cell, while minimizing the risk of damaging the cell. The convexly arced contact surface together with the biasing means provides tolerance to align the probe and the target, and allows the probe to contact the target cell even in case of difficult contacting parameters, for example if the battery case is elastic and/or deformed in an irregular manner, for example in the vicinity of a so called "bat ear".

In a preferred embodiment which may be combined with the previous one, the conductor and the biasing member are formed integrally. Preferably, the biasing member and the conductor can be made comprising the same material or consist of the same material. In a preferred embodiment, the probe including the integrally formed conductor and biasing member may be made of a conductive polymer. By providing the biasing member and the conductor of the probe as one single integral body, mechanical and electrical interferences along interfaces can be avoided. It is also easier to install and replace the probe including the conductor and biasing member as a single integral component.

According to another preferred embodiment, which may be combined with the previous one, the conductor and/or the biasing member comprise, in particular are realized as, a sheet of metal. In particular, the conductor and/or the biasing means can comprise or be realized as a sheet of stainless steel. It may be preferred that the sheet of metal has a thickness of less than 1 mm, preferably less than 0.5 mm, more preferably less than 0.3 mm, in particular less than 0.15 mm. The sheet of metal may have a thickness of no less than 0.001 mm, in particular no less than 0.01 mm, preferably no less than 0.05 mm. It could be demonstrated that stainless steel provides on the one hand adequate conductivity for measuring and resiliency to allow for deformation of the probe to engage with but not damage the target pouch-type battery cell, while also providing a high degree of wear resistance. Especially for probes which are frequently brought into engagement with a sealed and/or severed edge of a pouch-type battery case, the sharp pouch edge practically cutting the contact surface may severely wear down the probe.

In a preferred embodiment of the device, which may be combined with the aforementioned ones, the biasing member comprises a spiral-shaped spring. The spiral shaped spring may in particular be a mainspring. The width direction of the arced contact surface preferably corresponds to an axial direction of the spiral-shape. A spiral-shaped spring may include at least 0.5 windings, in particular at least 1.0 windings, preferably at least 1.25 windings, more preferably at least 1.5 windings. Alternatively or additionally, the spiral-shaped spring may include no more than 10 windings, in particular no more than five windings, preferably no more than two windings. The skilled person understands that one winding refers to a spiraling revolution of 360°. Spiral windings for between 250° and 750°, in particular between 300° and 600°, preferably approximately 540° or approximately 450°, may lead to particularly advantageous properties. A mainspring may refer to a band-like body, preferably of constant width and/or of constant thickness, revolving around a center point in the thickness direction with a continuously decreasing diameter. The inner end and/or outer end of the spiral-shaped spring, in particular the mainspring, may be provided with a radially protruding terminal section. The spring may be provided with an inner end provided with a radially inward protruding terminal section. A radially inward protruding inner end may stabilize the spiral-shaped spring, in particular the mainspring. Additionally or alternatively, the spiral-shaped spring, in particular the mainspring, may be provided with an outer end provided with a radially outward protruding terminal section. A radially inward or outward protruding terminal section end may serve for mounting the spiral-shaped spring to a holding member or the like. An inner and/or outer terminal section may in particular be aligned in the first direction.

In another embodiment, that may be combined with the previous ones, the probe comprises two or more arced contact surfaces. In particular, the two or more arced contact surfaces may be provided with a respective biasing member. Preferably, each arced contact surface is associated with one respective individual biasing member. For example, the probe may be provided with two arced contact surfaces each connected with its own biasing member, wherein preferably each arced contact surface is formed integrally with the respective biasing member. A probe comprising multiple arced contact surfaces, for instance on two spiral-shaped spring, in particular mainsprings, may be used to increase the contact area between the probe and the battery cell to be measured.

Optionally, in a preferred embodiment that may be combined with the previous ones, the device may further comprise a holding member. The holding member is configured for fixing a section, such as a terminal outer section, of the biasing member distal from the conductor. The section may in particular be an end, such as an outer or inner terminal end, of the biasing member opposite from the conductor in the first direction. By providing the end configured for being held by the holding member on the opposite end of the biasing member with respect to the conductor, especially its contact surface, the entire volume of the biasing member may be used to provide resiliency and deflection for elastically adapting to the contact surface of the target pouch-type battery cell.

In a further development of a device comprising a holding member, the holding member may in particular be a clamp and/or comprise a serrated holding surface. It may be preferred that the holding member has two opposing serrated holding surfaces of complementary shape, such that protrusions of the first pad (jaw) of the holding member protrude into receptions in a second pad of the second holding member. The holding member using complementary serrated holding surfaces may provide a positive engagement for securely holding the probe.

In a further development which may be combined with the above, the holding member may be movable to engage the biasing member in a second direction crosswise from the first direction. In particular, the second direction may be perpendicular with respect to the first direction. Preferably, the holding member is movable to engage the biasing member in a spring loaded manner or using at least one fastening bolt for fastening the biasing member. A spring loaded holding member may be referred to as a clip-type holding member. The holding member may be configured for gripping two opposing side surfaces of the biasing member, in particular using serrated holding surfaces (jaws).

In another further development of a device comprising a holding member, which may be combined with the ones above, the holding member may comprise or consist of a conductive material, in particular metal, such as brass. Using a conductive holding member improves the performance of electrical measurements including insulation voltage measurements.

The disclosure also relates to a system for measuring at least one electrical parameter, in particular an insulation voltage, of a battery cell comprising at least one device as described above, in particular two or more, for example three or four, devices as described above. In a particularly preferred embodiment, the device includes precisely two devices as described above or precisely four devices as described above. The system may be adapted to a predefined group of pouch-type battery cells having uniform dimensions. The system may be adapted such that the two or more devices are arranged to engage predetermined target positions on the battery cell to be measured, in particular the sealed edge thereof, for example adjacent to a first or second electrode lead of the pouch-type battery cell and/or in corner areas of the pouch-type battery cell.

The system for measuring at least one electrical parameter furthermore comprises a current- and/or voltage ensor. In particular, the conductor of the at least one probe is electrically coupled to the current- and/or voltage-sensor. It may be preferred that the conductor is electrically coupled to a voltage sensor so as to determine a voltage, particularly the insulation voltage, in particular between a point of contact of the probe and at least one reference point. The system may further comprise a at least one reference connection for contacting the first electrode lead, the second electrode lead and/or an electrical ground. the reference connection may be electrically coupled to the voltage sensor. The system may comprise one or more several voltage sensors connected with the two or more devices. It may be preferred that the two or more devices use the same voltage sensor or voltage sensors. The system may be equipped wih one single (shared) voltage sensor electrically coupled to the probes of the two or more devices. It may be preferred that the system is part of an assembly including the at least one, preferably precisely one, target pouch-type battery cell.

According to a further aspect of the present disclosure, a method is provided for measuring at least one electrical parameter, in particular an insulation voltage, of a battery cell, in particular a pouch type battery cell, using one or more devices as described above. In the method, a battery cell to be measured is provided, in particular a target pouch-type battery cell, comprising a sealed edge portion. In the method for measuring at least one electrical parameter, in particular an insulation voltage, the conductor is brought into engagement with the sealed edge portion in the first direction. As the conductor is brought into engagement with the pouch-type battery cell and the first direction, a deflection using the biasing means may occur.

In a preferred embodiment of a method for measuring at least one electrical parameter, in particular the insulation voltage, of a battery cell, in particular a pouch type battery cell, the electrical parameter(s), in particular the insulation voltage, of the pouch-type battery cell to be measured is determined while the conductor remains in engagement with the at least one sealed edge portion of the pouch-type battery cell.

In a preferred embodiment of a method for measuring at least one electrical parameter, in particular the insulation voltage, of a battery cell, in particular a pouch type battery cell, the at least one conductor is moved, preferably translationally or in a pivoting manner, in a direction crosswise from the first direction. The movement direction of the conductor may in particular be perpendicular with respect to the first direction. By moving the conductor along the sealed edge portion in the direction crosswise from the first direction, preferably the second direction, the arced contact surface moves, preferably glides, along the sealed edge section of the battery cell to be measured. By moving the conductor along the sealed edge section, electrical parameter, in particular the insulation voltage, can be probed at multiple target positions and/or a reference positions along the edge of the pouch-type battery case, thus realizing a particularly realiable measuring method, in this further development, it may be preferred to use a conductor comprising or being made of a sheet of metal, in particular stainless steel, preferably formed integrally with the biasing member, in particular as a spiral-shaped spring, particularly a mainspring. The preferred embodiments of the method can be applied in combination or individually.

### ADVANTAGEOUS EFFECTS

According to the embodiments, a particularly reliable and resilient device, system and method for measuring at least one electrical parameter, in particular insulation voltage, of a pouch-type secondary battery can be provided in comparison to prior art designs, and damage of the battery case or probe may be avoided. Furthermore, a significant increase in longlivety of probes may be achieved according to the embodiments. Accordingly, it becomes easy to maintain, install and/or detach measurement devices.

The effects of the present disclosure are not limited to the effects mentioned above and additional other effects not described above will be clearly understood from the description of the appended claims by those skilled in the art.

### BRIEF DESCRIPTION OF THE DRAWINGS

- FIG. 1: is a schematic sectional view of an apparatus for forming a secondary battery;
- FIG. 2: is a schematic view of a system including two devices for measuring at least one electrical parameter, in particular an insulation voltage, of a pouch-type battery cell;
- FIG. 3a: is a schematic view of a holding member in a first state fixing a probe;
- FIG. 3b: is a schematic view of the holding member of FIG. 3a in a second state releasing fixing said probe;
- FIG. 4: is a schematic illustration of another probe;
- FIG. 5: is a schematic illustration of a dual probe; and
- FIG. 6: is a schematic illustration of a third probe.

### DETAILED DESCRIPTION OF THE EMBODIMENTS

Hereinafter, various embodiments of the present disclosure will be described in detail with reference to the accompanying drawings so that those skilled in the art can easily carry out them. The present disclosure can be modified in various different ways, and is not limited to the embodiments set forth herein.

Portions that are irrelevant to the description will be omitted to clearly describe the present disclosure, and like reference numerals designate like elements throughout the description.

Further, in the drawings, the size and thickness of each element are arbitrarily illustrated for convenience of description, and the present disclosure is not necessarily limited to those illustrated in the drawings. In the drawings, the thickness of layers, regions, etc. are exaggerated for clarity. In the drawings, for convenience of description, the thicknesses of some layers and regions are exaggerated.

In addition, it will be understood that when an element such as a layer, film, region, or plate is referred to as being "on" or "above" another element, it can be directly on the other element or intervening elements may also be present. In contrast, when an element is referred to as being "directly on" another element, it means that other intervening elements are not present. Further, the word "on" or "above" means disposed on or below a reference portion, and does not necessarily mean being disposed on the upper end of the reference portion toward the opposite direction of gravity. Meanwhile, similarly to the case where it is described as being located "on" or "above" another part, the case where it is described as being located "below" or "under" another part will also be understood with reference to the above-mentioned contents.

Further, throughout the description, when a portion is referred to as "including" or "comprising" a certain component, it means that the portion can further include other components, without excluding the other components, unless otherwise stated.

Further, throughout the description, when referred to as "planar", it means when a target portion is viewed from the upper side, and when referred to as "cross-sectional", it means when a target portion is viewed from the side of a cross section cut vertically.

Hereinafter, a pouch-type battery case, and a device and system for measuring electrical properties, in particular an insulation voltage, of the pouch-type battery cell are described with reference to the accompanying drawings.

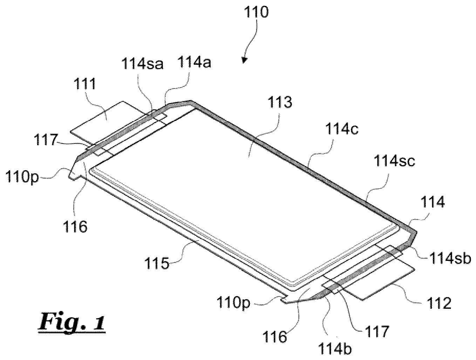

FIG. 1 illustrates an exemplary pouch-type battery cell 110. For example, the pouch-type battery cell 110 has a structure in which two electrode leads 111 and 112 protrude from a first end 114a and a second end 114b opposite the first end 114a of the cell main body 113. A plurality of battery cells 110 may be stacked forming a battery cell stack. In particular, the electrode leads 111 and 112 are connected to an electrode assembly inside of the pouch-type battery (not shown), and protrude from the electrode assembly (not shown) to the outside of the battery cell 110. For example, a first electrode tab 111 projects from a first side of the electrode assembly and may be operatively coupled to negative electrodes, and a second electrode tab 112 protrudes on a second side of the electrode assembly and is operatively coupled to the positive electrodes. The electrode tabs 111, 112 may each be provided with a respective insulation part 117 configured for being arranged between the corresponding overlapping side portions 114a or 114b of the battery case 114. The pouch-type battery cell 110 contains an electrode assembly comprising a positive electrode, a negative electrode and a separator between the positive and negative electrode, and an electrolyte solution. The electrode assembly and the electrolyte solution are encapsulated by the cell case 114.

The cell case 114 may be formed of a laminated sheet (pouch film) containing at least one resin layer and at least one metal layer. The cell case 114 serves as a mechanical barrier, a fluid barrier and as an electrical barrier to protect the internal electrode assembly and electrolyte solution and the surroundings from each other. The cell case 114 forms a barrier between the internal electrode assembly and electrolyte solution and the external surroundings, leaving the electrode leads 111, 112 to as the only electrical conduits.

The pouch film may have a laminate structure comprising, for example, a metal film and one or more synthetic material layers. For example, the metal film may be made of aluminum (Al), iron (Fe), copper (Cu), chrome (Cr), manganese (Mn), nickel (Ni), magnesium (Mg), zinc (Zn) or a combination or an alloy thereof. For example, the one synthetic material layer, or each of the synthetic material layers, may be made of or contain polyethylene, polypropylene, polycarbonate, polyethylene terephthalate, polyvinyl chloride, acryl-based polymer, polyacrylonitrile, polyimide, polyamide, cellulose, aramid, nylon, polyester, polyparaphenylene, benzobisoxazole, polyarylate, Teflon, glass fiber or a combination thereof. The pouch film has a film thickness. The film thickness is preferably constant and/or continuous in the crosswise film direction. The film thickness is preferably constant and/or continuous in the longitudinal film direction. The pouch film has a first surface, which in particular is configured for acting as an inner surface of pouch-type battery case, and a second surface, which in particular is configured for acting as an outer surface of the pouch-type battery case. The first surface may be in engagement with the electrode assembly placed in order to be placed within the pouch-type battery case. The second surface may face away from the electrode assembly and optionally be in engagement with the environment surrounding the secondary battery.

The pouch film may have a pouch film thickness of 100 µm to 250 µm, in particular 160 µm to 200 µm, preferably 175 µm to 190 µm. Preferably, the pouch film includes a gas barrier layer which is made of metal. The metal of the gas barrier layer of the pouch film preferably comprises or consists of aluminum and/or an alloy containing aluminum, particularly including an alloy no. AA80XX series aluminum alloy. The alloy no. of the aluminum alloy may be AA8021. The aluminum alloy may include about 1.3 wt% to about 1.7 wt% of iron and about 0.2 wt% or less of silicon, and may have a grain size of about 10 µm to about 13 µm. The thickness of the gas barrier layer may be 30 µm to 150 µm, in particular 70 µm to 120 µm, preferably 80 µm to 100 µm. The pouch film may further include a sealant layer made of a first polymer, preferably formed as an innermost layer. The thickness of the sealant layer may be 60 µm to 100 µm. Additionally or alternatively, the pouch film may include a surface protection layer made of a second polymer, preferably formed as an outermost layer. The first polymer may be the same as the second polymer or different from the second polymer. In particular, the gas barrier layer is stacked between the surface protection layer and the sealant layer. The pouch film may further include a drawing assistance layer which is made of a third polymer. The third polymer may be the same as or different from the first and/or second polymer. The drawing assistance layer may be stacked between the surface protection layer and the gas barrier layer. A thickness of the drawing assistance layer may be 10 µm to 75 µm, particularly 20 µm to 50 µm.

The first polymer may be made of one or more materials selected from the group consisting of polyethylene, polypropylene, polycarbonate, polyethylene terephthalate, polyvinyl chloride, acryl-based polymer, polyacrylonitrile, polyimide, polyamide, cellulose, aramid, nylon, polyester, polyparaphenylene benzobisoxazole, polyarylate, Teflon, and glass fiber. In particular, polyolefin-based resin such as polypropylene (PP) or polyethylene (PE) may be a main component in the first polymer. Polypropylene (PP) may provide excellent mechanical properties including tensile strength, rigidity, surface hardness, wear resistance, and thermal resistance, and excellent chemical properties including corrosion resistance and therefore be selected as a main component of the sealant layer.

The second polymer may be made of one or more from polyethylene, polypropylene, polycarbonate, polyethylene terephthalate, polyvinyl chloride, acryl-based polymer, polyacrylonitrile, polyimide, polyamide, cellulose, aramid, nylon, polyester, polyparaphenylene benzobisoxazole, polyarylate, Teflon, and glass fiber. It may be advantageous to mainly use a polymer having a desirable wear resistance and thermal resistance, such as polyethylene terephthalate (PET).

The third polymer may be made of one or more from polyethylene, polypropylene, polycarbonate, polyethylene terephthalate, polyvinyl chloride, acryl-based polymer, polyacrylonitrile, polyimide, polyamide, cellulose, aramid, nylon, polyester, polyparaphenylene benzobisoxazole, polyarylate, Teflon, and glass fiber. Particularly, a nylon resin may be easily bonded to the polyethylene terephthalate (PET) of the surface protection layer and may exhibit a similar behavior to the aluminum alloy of the moisture barrier layer during and after a drawing process. Thus, a nylon resin may be used as a main component of the third polymer.

In the present examples, a battery cell to be tested is exemplarily illustrated as a pouch type battery cell 110. The skilled person understands that the battery cell to be measured may in some preferred embodiments be realized as a pouch type battery cell 110, however, alternatively, the device, system or method as described herein can be applied to another type of battery cell. The illustrated pouch type battery cell 110 may for example be manufactured by folding two portions of a foil to form the cell case 114 to surround and encapsulate the internal electrode assembly. The cell case 114 may be folded about a folding portion 115 dividing the cell case 114 into the two portions. Thereby, the respective left lateral side parts 114a of the two portions are folded onto one another, and the right lateral side parts 114b are also folded onto one another. Futhermore, a pair of middle parts 114c of each portion, the middle parts 114c being distal from the folding portion 115, are folded onto each other. In order to sealingly close the pouch type battery cell 110, the pairwise overlapping parts 114a, 114b, 114care sealingly attached to one another, Thereby, sealed edge portions 114sa, 114sb and 114sc are formed. These sealed portion 114sa, 114sb and 114sc may have a structure formed by a method such as heat fusion or friction welding. It is conceivable that the overlapping top and bottom middle parts 114c, which may be sealed middle parts 114c, attached to one another are folded once or more towards the folding part as a flap 114f. Optinally, the folding part 115 may also be subjected to an attachment method. It may, however, be preferred that the folding part 115 provides a sealing function through the material properties of the foil forming the cell case 114 including the folding part 115, in particular without additional attachment or sealant.

The folding part 115 may extend long along one edge of the battery cell 110. In some embodiments, a protrusion part 110p (a so called "bat-ear") of the battery cell 110 may be formed at a cordner of the folding part 115 and the respective adjacent left or right lateral side part 114a, 114b. Additionally or alternatively, while the cell case 114 is sealed with the protruding electrode leads 111 and 112 being interposed therebetween, a terrace part 116 may be formed between the electrode leads 111 and 112 and the cell main body 113. That is, the battery cell 110 may include a terrace part 116 formed to extend from the cell case 114 in the direction in which the electrode lead 111 and/or 112 protrudes.

The cell case must be mechanically firm and form a sealingly tight encapsulation around the internal battery components. In case of leakage of electrolyte solution through the cell case 114, or in case of an electrical connection of one or both of the electrode leads 111, 112, or the internal electrode assembly with the cell case 114, the battery cell 110 is defective. Defective batteries must be identified and sorted out to avoid their use in battery stacks, which could lead to suboptimal performance or even pose a hazard.

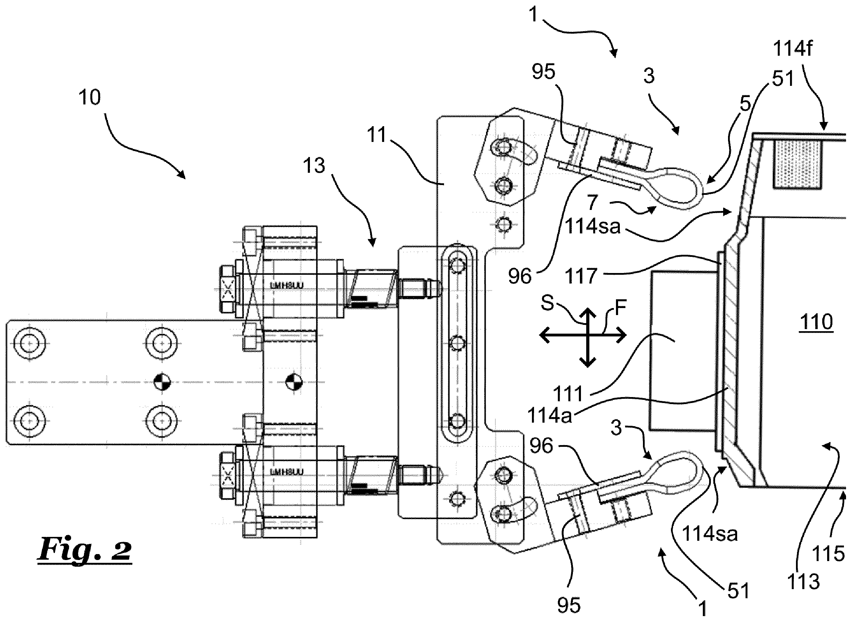

FIG. 2 shows a pouch type-battery cell 110 like the one described above, in combination with a system 10 including two devices 1 for measuring at least one electrical parameter, in particular an insulation voltage, of a pouch-type battery cell. The system may preferably include one voltage sensor (not shown) electrically connected to the two devices 1. The devices 1 are connected to the system 10 such that they are movable in a forward direction F for engagement with the (left) lateral edge 114a of the pouch-type battery case 114. The devices 1 are laterally spaced apart to be brought into contact with the sealed edge portion 114sa adjacent to the first electrode lead 111 of the pouch-type battery 110 and the isolator 117 surrounding the lead 111 interposed between the lead 111 and the pouch foil forming the battery case 114.

Each device 1 has a respective holding member 9 to which and respective probe 3 integrally formed from the conductor 5 and biasing means 7 is firmly attached. A fastening bolt 95 is screwed into the holding member 9 to firmly press a holding plate 96 onto opposite terminal ends of the probe and against a side of the holding member 9.

Each probe 3 has a respective conductor 5 with an arced contact surface 51. The conductors 5 form a 180 ° curve with an arced contact surface 51 on their outer circumference. The width of the respective contact surface 51 extends in the viewing direction as well as the axis around which the radius arced contact surfaces 51 are bent. The width of the conductor 5 has a diameter approximately two times as large as the radius of curvature of the arced contact surface 51. The probes 3 may preferably be made of a conductive material, such as a conductive rubber or sheet metal. The probes 3 of the several devices 1 of the system 10 may have the same dimensions. For example, the probes 3 may be loop-shaped, having to opposing terminal ends lying on top of each other against the holding member 9 opposite, in the first direction F, to the arced contact surface 51.

The holding members 9 are hingedly coupled to a support bracket 11 of the system 10. The holding members 9 may be rigidly coupled to the support bracket 11 to set a predefined lateral distance between the adjacent devices 1, for example in accordance with a predetermined measuring distance corresponding to a predetermined pouch-type battery cell 110. The system 10 may comprise a linear actuator 13 to move the devices 1 translationally forward and backward in the first direction F for engagement and disengagement with respect to the target pouch-type battery cell 110. The devices 1 can in particular be moved forward in the first direction F so as to be brought into contact engagement with a pouch-type battery cell 110 with the convex arced surface 51 of the conductor 5 to create a mechanical and electrical connection. When the probe 3 contacts the pouch-type battery cell 110, the biasing means 7 resiliently urges the conductor 5 against the pouch-type battery cell 110 to create a reliable electrical connection. The resiliency of the biasing means 7 also allows the probe 3 to deform in response to the engagement with the pouch-type battery cell 110 to avoid damaging the cell or the probe.

The system 10 may further be configured for moving one or more devices 1 in a second direction S. One or more devices may in particular be moved in a sliding engagement with the pouch-type battery cell. For example, the probe 3 may be moved in a skid-like manner such that the convex arced contact surface 51 slides along a seald edge portion 114sa, 114sb or 114sc.

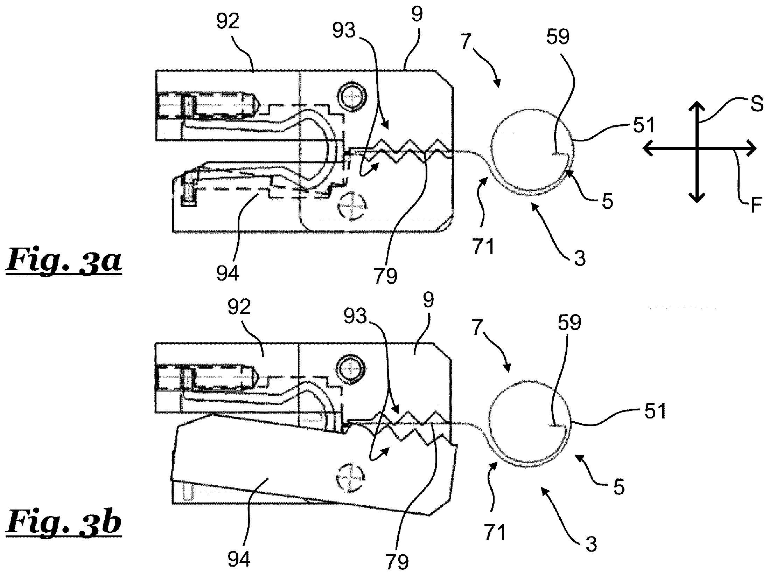

FIGS. 3a and 3b as well as FIGS. 4-6 illustrate different embodiments of probes 3 for engaging target pouch-type battery cells 110.

FIG. 3a shows a holding member 9 in a closed state fixing a probe 3; and FIG. 3b shows the holding member 9 in an open state releasing fixing said probe 3. The width of the conductor 5 has a diameter approximately two times as large as the radius of curvature of the arced contact surface 51.

In FIGS. 3a and 3b, a clip-type holding member 9 having opposing jaws 92, 94 are shown. A first jaw 92 may be configured for attaching to a support bracket of a system 10. The second jaw 94 may be rotatably connected to the first jaw 92 in a spring loaded manner urging the second jaw 94 against the first jaw 92 such that their serrated contact surfaces 93 are brought into positive engagement. An end section 79 of the biasing means 7 of a probe 3 may be held in positive engagement by the jaws 92, 94 in the closed state of the holding member 9. The probe 3 is thereby held firmly against displacement in the second direction S, and securely in electrical connection with the holding member which may be made of an electrically conducting material, such as a metal, particularly brass. When the holding member 9 is in an open state, the second jaw 94 is removed from the first jaw 92 so that the probe 3 may easily be removed and replaced.

The probe 3 in FIGS. 3a and 3b has a spiral shape including a 540 ° winding. The inner terminal end 59 and the end section 79 of the probe body are oriented parallel to the first direction F so as to rigidify the probe in the axial direction. The outer radius of diameter of the conductor 5 and biasing member 7 may be approximately 25 mm. The inner terminal end 59 is approximately half as large as the radius of the conductor 5. The outer protrusion forming the end section 70 distal from the arced contact surface 51 is longer than the width and/or diameter of the conductor 5. The convexely curved contact surface 51 formed on its outer circumference. The contact surface 51 faces in the first direction F to be brought into engagement with a target pouch-type battery (not shown).

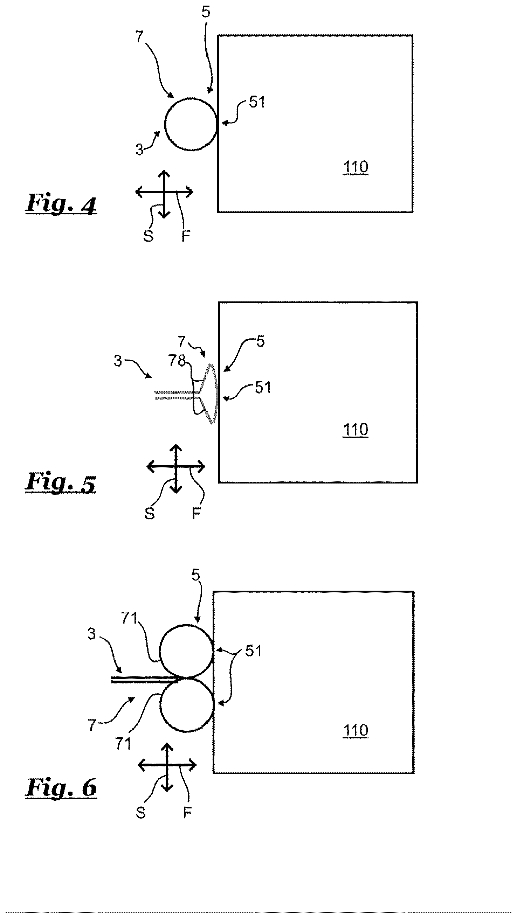

FIG. 4 is a schematic illustration of another probe 3 engaging a schematically illustrated pouch-type battery cell 110. The schematically illustrated probe 3 as a circular shape including a biasing means 7 as well as a conductor 5 with an arced contact surface 51 engaging a measurement position on an edge of the pouch-type battery cell. The width of the conductor 5 has a diameter approximately two times as large as the radius of curvature of the arced contact surface 51. The contact surface 51 faces in the first direction F to be brought into engagement with the target pouch-type battery 110.

FIG. 5 shows a probe 3 similar the above-mentioned loop-shaped probe described in conjunction with the system of FIG. 1. The convex arced contact surface 51 in the embodiment of FIG. 5 has a particularly large radius of curvature larger than the width of the conductor 5. The large radius of curvature allows to flatten the contact surface 51 so as to increase the contact area with the pouch-type battery cell 110, preferably to a line contact. The arced contact surface 51 is connected with two terminal sections, both protruding radially inward. The arc-section contact surface 51 faces in the first direction F to be brought into engagement with the target pouch-type battery. The arc-section extends over less than 180°, in particular less than 90°, preferably less than 60°, more preferably less than 45°. The terminal sections 78 form an acute angle with respect to one another. The terminal sections 78 are preferably arranged in a mirror symmetrical manner with respect to the first direction F.

FIG. 6 is a schematic illustration of a dual probe 3 including two pairs of integrally formed conductors 5 and biasing members 7, each realized as a respective mainspring 71. The holding section 79 distal from the arced contact surface 51 protrude tangentially from the circular or spiral-shaped body. The contact surface 51 faces in the first direction F to be brought into engagement with the target pouch-type battery 110. The conductors 5 and biasing members 7 are preferably arranged in a mirror symmetrical manner with respect to the first direction F. The holding sections 79 may lie flat against each other, and may be firmly held by the same holding member (not shown). Circular or spiraling combinations of biasing member 7 and conductor 5 may extend from the forward end of the holding sections. By providing a dual probe with two arced contact surfaces 51, the contact area between the probe 3 and the target battery cell 110 may be significantly increased. The adjacent conductors 5 have a respective diameter approximately two times as large as the radius of curvature of the arced contact surface 51.

### LIST OF REFERENCE NUMERALS

- 1: device
- 3: probe
- 5: conductor
- 7: biasing member
- 9: holding member
- 10: system
- 51: contact surface
- 59: inner terminal end
- 71: mainspring
- 79: section (distal from conductor)
- 91: clamp
- 92, 94: jaw
- 93: serrated holding surface
- 95: fastening bolt
- 96: holding plate
- 110: battery cell
- 110p: projection ("bat ear")
- 111: first electrode lead
- 112: second electrode lead
- 113: cell main body
- 114: cell case
- 114a: (left) lateral side part
- 114b: (right) lateral side part
- 114c: middle part
- 114sa: sealed portion
- 114sb: sealed portion
- 114sc: sealed portion
- 114f: flap
- 115: foldin gportion
- 116: terrace
- 117: insulation part
- F: first direction
- S: second direction

## Claims

1. A device (1) for measuring at least one electrical parameter, in particular an insulation voltage, of a battery cell, comprising:
at least one probe (3) including
- a conductor (5) configured for electrically coupling to a current- and/or voltage-sensor; wherein the conductor (5) has an arced contact surface (51) configured for engaging the battery cell to be measured; and
- a biasing member (7) configured for mounting the conductor (5) resiliently a the first direction (F).

2. The device (1) of claim 1, wherein a convex side of the contact surface (51) is oriented to face the battery cell to be measured in the first direction (F).

3. The device (1) of claim 1 or 2, wherein the conductor (5) and the biasing member (7) are formed integrally.

4. The device (1) of one of the preceding claims, wherein the conductor (5) and/or the biasing member (7) comprise a sheet of metal, in particular stainless steel.

5. The device (1) of one of the preceding claims, wherein the biasing member (7) comprises a spiral-shaped spring.

6. The device (1) of one of the preceding claims, wherein the contact surface (51) is arranged on a lateral surface of the biasing member (7).

7. The device (1) of one of the preceding claims, wherein the probe (3) comprises two or more arced contact surfaces (51).

8. The device (1) of one of the preceding claims, further comprising a holding member (9) configured for fixing a section of the biasing member (7) distal from the conductor (5).

9. The device (1) of claim 8, wherein the holding member (9) comprises a clamp (91) and/or a serrated holding surface (93).

10. The device (1) of claim 8 or 9, wherein the holding member (9) is moveable to engage the biasing member (7) in a second direction (S) crosswise from the first direction (F), in particular perpendicular with respect to the first direction (F.

11. The device (1) of one of the claims claim 8 to 10, wherein the holding member (9) comprises a conductive material, in particular metal, such as brass.

12. A system (10) for measuring at least one electrical parameter, in particular an insulation voltage, of a battery cell comprising at least one device (1) according to one of the preceding claims and a current- and/or voltage-sensor.

13. A method for measuring at least one electrical parameter, in particular an insulation voltage, of a battery cell using a device (1) according to one of the claims 1 to 11, wherein
- a battery cell to be measured is provided comprising a sealed edge portion (114sa, 114sb, 114sc);
- the conductor (5) is brought into engagement with the sealed edge portion (114sa, 114sb, 114sc) in the first direction (F).

14. The method of claim 11, wherein the electrical parameter, in particular the insulation voltage, of the battery cell to be measured is determined while the conductor (5) remains in engagement with the at least sealed edge portion (114sa, 114sb, 114sc).

15. The method of claim 13 or 14, wherein the conductor (5) is moved along the sealed edge portion (114sa, 114sb, 114sc) in a direction crosswise from the first direction (F), in particular perpendicular with respect to the first direction (F), such that the arced contact surface moves along the sealed edge portion (114sa, 114sb, 114sc) of the battery cell to be measured.

## Amended claims

### Amended claims in accordance with Rule 137(2) EPC.

1. A device (1) for measuring at least one electrical parameter of a battery cell, comprising:
at least one probe (3) including
- a conductor (5) configured for electrically coupling to a current- and/or voltage-sensor; wherein the conductor (5) has an arced contact surface (51) configured for engaging the battery cell to be measured; and
- a biasing member (7) configured for mounting the conductor (5) resiliently in a first direction (F),
wherein the conductor (5) and the biasing member (7) are formed integrally.

2. The device (1) of claim 1, wherein a convex side of the contact surface (51) is oriented to face the battery cell to be measured in the first direction (F).

3. The device (1) of one of the preceding claims, wherein the conductor (5) and/or the biasing member (7) comprise a sheet of metal, in particular stainless steel.

4. The device (1) of one of the preceding claims, wherein the biasing member (7) comprises a spiral-shaped spring.

5. The device (1) of one of the preceding claims, wherein the contact surface (51) is arranged on a lateral surface of the biasing member (7).

6. The device (1) of one of the preceding claims, wherein the probe (3) comprises two or more arced contact surfaces (51).

7. The device (1) of one of the preceding claims, further comprising a holding member (9) configured for fixing a section of the biasing member (7) distal from the conductor (5).

8. The device (1) of claim 7, wherein the holding member (9) comprises a clamp (91) and/or a serrated holding surface (93).

9. The device (1) of claim 7 or 8, wherein the holding member (9) is moveable to engage the biasing member (7) in a second direction (S) crosswise from the first direction (F), in particular perpendicular with respect to the first direction (F).

10. The device (1) of one of the claims 7 to 9, wherein the holding member (9) comprises a conductive material, in particular metal, such as brass.

11. A system (10) for measuring at least one electrical parameter of a battery cell comprising at least one device (1) according to one of the preceding claims and a current- and/or voltage-sensor.

12. A method for measuring at least one electrical parameter of a battery cell using a device (1) according to one of the claims 1 to 10, wherein
- a battery cell to be measured is provided comprising a sealed edge portion (114sa, 114sb, 114sc);
- the conductor (5) is brought into engagement with the sealed edge portion (114sa, 114sb, 114sc) in the first direction (F).

13. The method of claim 12, wherein the electrical parameter of the battery cell to be measured is determined while the conductor (5) remains in engagement with the at least sealed edge portion (114sa, 114sb, 114sc).

14. The method of claim 12 or 13, wherein the conductor (5) is moved along the sealed edge portion (114sa, 114sb, 114sc) in a direction crosswise from the first direction (F), in particular perpendicular with respect to the first direction (F), such that the arced contact surface moves along the sealed edge portion (114sa, 114sb, 114sc) of the battery cell to be measured.
